# EUROPÄISCHE PATENTANMELDUNG

(11) **EP 3 082 169 A1**
(43) Veröffentlichungstag der Anmeldung: **19.10.2016**
(21) Anmeldenummer: 15001126.0
(22) Anmeldetag: 17.04.2015
(51) Int. Cl.: H01L 31/0304, H01L 31/167, H01L 25/16

(54) **STAPELFÖRMIGER OPTOKOPPLERBAUSTEIN**

(71) Anmelder: AZUR SPACE Solar Power GmbH, 74072 Heilbronn (DE)
(72) Erfinder: Guter, Wolfgang, 70190 Stuttgart (DE); Fuhrmann, Daniel, 74074 Heilbronn (DE); Wächter, Clemens, 74348 Lauffen am Neckar (DE)
(74) Vertreter: Koch Müller Patentanwaltsgesellschaft mbH

(57) **Zusammenfassung**

Stapelförmiger Optokopplerbaustein, aufweisend einen Senderbaustein (S) mit einem Sendebereich (SF), einen Empfängerbaustein (E) mit einem Empfangsbereich (EF) und einen plattenförmigen elektrischen Isolator (IS), wobei der Isolator zwischen dem Senderbaustein und dem Empfängerbaustein ausgebildet ist. Der Senderbaustein (S), der Empfängerbaustein (E) und der Isolator (IS) sind stapelförmig aufeinander angeordnet, wodurch der Senderbaustein und der Empfängerbaustein voneinander galvanisch getrennt jedoch miteinander optisch gekoppelt sind. Der Isolator (IS) ist für die Emissionswellenlängen des Senderbausteins (E) transparent. Eine Schwerelinie der Oberfläche des Sendebereichs und eine Schwerelinie der Oberfläche des Empfangsbereichs sind im Wesentlichen zueinander parallel, und der Versatz zwischen den beiden Schwerelinien ist kleiner als die Hälfte der Entfernung der jeweiligen Schwerelinien zu einer Außenkante des Sendebereichs oder zu einer Außenkante des Empfangsbereichs, so dass das Licht des Senderbausteins überwiegend durch den Isolator auf den Empfängerbaustein einwirkt. Der Empfängerbaustein (E) weist eine Anzahl N zueinander in Serie geschalteter Teilspannungsquellen auf, wobei N eine natürliche Zahl ist. Die Abweichungen der Teilspannungen der einzelnen Teilspannungsquellen untereinander sind kleiner als 20%. Jede der Teilspannungsquellen weist eine Halbleiterdiode (D1 - D4) mit einem p-n Übergang auf. Zwischen jeweils zwei aufeinanderfolgenden Teilspannungsquellen ist eine Tunneldiode (TD1-TD3) ausgebildet. Die Teilspannungsquellen und die Tunneldioden sind zusammen monolithisch integriert. Durch diese neuartige Anordnung lassen sich sehr kompakte und kleine Optokopplerbausteine herstellen, die eine hohe Schaltgeschwindigkeit aufweisen.

## Beschreibung

Die Erfindung betrifft einen stapelförmigen Optokopplerbaustein.

Aus der DE 100 11 258 A1, der US 2014 004 234 4 A1, der US 2014 021 208 5 A1, der DE 33 17 054 A1, der US 2006 006 095 5 A1, der US 4 127 862, der DE 3 633 181 A1 und der US 4 996 577 sind unterschiedliche Optokopplerbausteine bekannt.

Vor diesem Hintergrund besteht die Aufgabe der Erfindung darin, eine Vorrichtung anzugeben, die den Stand der Technik weiterbildet.

Die Aufgabe wird durch einen stapelförmigen Optokopplerbaustein mit den Merkmalen des Patentanspruchs 1 gelöst. Vorteilhafte Ausgestaltungen der Erfindung sind Gegenstand von Unteransprüchen.

Gemäß dem Gegenstand der Erfindung wird ein stapelförmiger Optokopplerbaustein bereitgestellt, aufweisend einen Senderbaustein mit einem Sendebereich, wobei der Sendebereich eine Oberfläche aufweist, und einen Empfängerbaustein mit einem Empfangsbereich, wobei der Empfangsbereich eine Oberfläche aufweist, und einen plattenförmigen elektrischen Isolator, wobei der Isolator zwischen dem Senderbaustein und dem Empfängerbaustein ausgebildet ist, und der Senderbaustein und der Empfängerbaustein und der Isolator stapelförmig aufeinander angeordnet sind und der Isolator eine Oberseite und eine Unterseite aufweist. Der Senderbaustein und der Empfängerbaustein sind galvanisch voneinander getrennt, jedoch miteinander optisch gekoppelt, wobei der Isolator wenigstens für ein Teil der Emissionswellenlängen des Senderbausteins transparent ist, und die Schwerelinie der Oberfläche des Sendebereichs und die Schwerelinie der Oberfläche des Empfangsbereichs im Wesentlichen oder exakt zueinander parallel sind, und der Versatz zwischen den beiden Schwerelinien kleiner als die Hälfte oder kleiner als ein Zehntel oder kleiner als ein fünfzigstel der Entfernung der jeweiligen Schwerelinien zu einer Außenkante der Oberfläche des Sendebereichs oder zu einer Außenkante der Oberfläche des Empfangsbereichs ist, so dass das Licht des Senderbausteins überwiegend oder ausschließlich durch den Isolator auf den Empfängerbaustein bzw. auf die Oberfläche des Empfangsbereichs und auf den Empfangsbereich einwirkt, und der Isolators auf allen Seiten aus dem Stapel balkonförmig um maximal 250 µm hervorsteht, und der Empfängerbaustein eine Anzahl N zueinander in Serie geschalteten Teilspannungsquellen aufweist, wobei N eine natürliche Zahl und N ≥ 2 ist, und die Abweichung der Teilspannungen der einzelnen Teilspannungsquellenuntereinander kleiner als 20% ist, und jede der Teilspannungsquellen eine Halbleiterdiode mit einen p-n Übergang aufweist, und zwischen jeweils zwei aufeinanderfolgenden Teilspannungsquellen eine Tunneldiode ausgebildet ist, wobei die Teilspannungsquellen und die Tunneldioden zusammen monolithisch integriert sind.

Es sei angemerkt, dass der Senderbaustein und der Empfängerbaustein in Form von sogenannten "Dies" vorliegen, d.h. als ungehäuste Bausteine. Ferner weist der Senderbaustein neben dem Sendebereich auch eine Rückseite und der Empfängerbaustein neben dem Empfangsbereich auch eine Rückseite auf. Insgesamt liegt vorzugsweise der gesamte Stapel als ungehäustes Bauteil vor. Des Weiteren sei angemerkt, dass die Anzahl N bevorzugt gleich vier ist.

Es versteht sich, dass mit dem Begriff transparent eine geringe Absorption zumindest im Bereich der Sendewellenlänge zu verstehen ist. Vorzugsweise ist die Absorption in Bezug auf die eingestrahlte Intensität kleiner als 20% oder kleiner als 10%, höchst vorzugsweise kleiner als 5%.

Des Weiteren versteht sich, dass bei dem Empfängerbaustein, genauer gesagt bei dem Empfangsbereich die Halbleiterdioden untereinander eine im Wesentlich gleiche oder eine genau gleiche Abfolge von Halbleiterschichten mit identischen oder im Wesentlichen identischen Halbleitermaterialien aufweisen und durch die Serienschaltung der Diode die Gesamtspannung des Empfängerbausteins die Summe der Teilspannungen ist. Hierdurch lässt sich auf einfache Weise eine nahezu identische Teilspannung der jeweiligen Halbleiterdioden erzielen. Vorzugsweise weicht die Teilspannung weniger als 10 % zwischen beliebigen zwei Halbleiterdioden des Stapels voneinander ab. Ferner sei angemerkt, dass mit einem zunehmenden Abstand der einzelnen Diode von dem Isolator die Dicke des Absorptionsbereichs und hiermit die Gesamtdicke der einzelnen Diode stark, vorzugsweise exponentiell zunehmen.

Ein Vorteil ist, dass durch die neuartige stapelförmige Anordnung von mehreren monolithischen Dioden in dem Empfängerbaustein verbunden mit einer hohen Lichtempfindlichkeit sich sehr kompakte und kleine Optokopplerbausteine herstellen lassen. Insbesondere lässt sich eine direkte Einkopplung des emittierten Lichts erzielen, d.h. das Licht hat einen kurzen Weg durch den Isolator zurückzulegen, bevor das transmittierte Licht auf den Empfängerbaustein trifft.

Ein weiterer Vorteil ist, dass der Empfängerbaustein neben einer hohen Spannung, vorzugsweise oberhalb 2 V, höchst vorzugsweise oberhalb von 4 V auch einen hohen Strom oberhalb von 1 mA / cm², höchst vorzugsweise oberhalb von 100mA / cm² zur Verfügung stellt. Hierdurch lassen sich hohe Schaltgeschwindigkeiten oberhalb 10 MHz, vorzugsweise oberhalb 100 MHz erzielen.

Des Weiteren sei angemerkt, dass es vorteilhaft ist, den Sendebereich unmittelbar mit der Oberseite des Isolators und den Empfangsbereich unmittelbar mit der Unterseite des Isolators zu verbinden, so dass der Sendebereich dem Empfangsbereich zugewandt ist. Hierdurch benötigt das emittierte Licht nur den minimalen Weg zu der Empfangsfläche, d.h. zu der Oberfläche des Empfangsbereichs.

In einer alternativen Ausführung sind die Rückseite des Senderbausteins mit der Oberseite des Isolators und die Rückseite des Empfängerbausteins mit der Unterseite des Isolators verbunden. Untersuchungen haben gezeigt, dass bei Ausbildung einer Substratschicht an der Rückseite des Senderbausteins und eine Ausbildung einer Substratschicht an der Rückseite des Empfängerbausteins eine vorteilhafte stapelförmige Ausbildung gegeben ist, anders ausgedrückt die beiden Substratschichten sind vorliegend unmittelbar einander zugewandt. Mit der Ausbildung von den Substratschichten lässt sich die mechanische Stabilität des jeweiligen Bausteins erhöhen und eine zuverlässige Kontaktierung der Bausteine durchführen.

In einer anderen Ausführungsform ist der Stapel aus Senderbaustein und Isolator und Empfängerbaustein in einem gemeinsamen Gehäuse integriert.

In einer bevorzugten Weiterbildung weist der Empfängerbaustein und der Senderbaustein entlang der Stapelrichtung eine pyramidenstumpfartige Ausbildung auf, wobei der Unterschied in der Flächengröße zwischen der Unterseite des Pyramidenstumpfs und der Oberseite des Pyramidenstumpfs wenigstens 5 µm² beträgt.

In einer Weiterbildung ist der Unterschied zwischen der Größe der Oberfläche des Sendebereichs und der Größe der Oberfläche des Empfangsbereichs kleiner als 20%, vorzugsweise kleiner als 10%. Untersuchungen haben gezeigt, dass es vorteilhaft ist, die Oberfläche des Empfangsbereichs entweder gleich groß wie die Oberfläche des Sendebereichs auszuführen, oder alternativ die Oberfläche des Empfangsbereichs maximal 20 % größer als die Oberfläche des Sendebereichs auszuführen.

Des Weiteren ist es bevorzugt, dass die gesamte Oberfläche des Sendebereichs und oder der Sendebereich Licht emittiert und die gesamte Oberfläche des Empfangsbereichs und der Empfangsbereich insgesamt Licht absorbiert. Hierdurch lässt sich der Wirkungsgrad des Optokopplerbausteins erhöhen. Es versteht sich, dass bei einer Emission des Lichts durch die Oberfläche des Sendebereichs eine möglichst geringe Fläche mit Kontaktmetall bedeckt ist. Nicht anders ergibt sich für den Fall der Absorption. Auch hier gilt bei einer Absorption des Lichtes durch die Oberfläche des Empfangsbereichs und in dem Empfangsbereich, dass eine möglichst geringe Fläche bzw. Flächenanteil an der gesamten Oberfläche des Empfangsbereichs mit Kontaktmetall bedeckt ist.

In einer Ausführungsform weist die Oberfläche des Sendebereichs und die Oberfläche des Empfangsbereichs eine viereckige Form auf, wobei die größte Kantenlänge des jeweiligen Vierecks kleiner als 2 mm ist. In einer Weiterbildung sind die Oberflächen des Sendebereichs und die Oberfläche des Empfangsbereichs quadratisch ausgebildet und weisen jeweils eine Grundfläche größer als 0,2 x 0,2 mm² und kleiner als 4 mm² oder kleiner als 1 mm² auf.

Des Weiteren ist es vorteilhaft, wenn die Oberflächen des Sendebereichs und die Oberfläche des Empfangsbereichs jeweils eine streifenförmige oder gitterförmige oder kleine Kontaktfläche mit einem Anteil von kleiner als 10% der gesamten Oberfläche oder eine ganzflächige Metallisierung aufweisen. Ferner weist die Rückseite des Senderbausteins als auch die Rückseite des Empfängerbausteins eine streifenförmige Kontaktfläche oder gitterförmige Kontaktfläche oder kleine Kontaktfläche mit einem Anteil von jeweils kleiner als 10% der gesamten Oberfläche oder eine ganzflächige Metallisierung auf.

In einer anderen Ausführungsform weist der Senderbaustein einen optischen Spiegel für die Wellenlänge des Senders oder eine RCLED oder einen oberflächenemittierenden Laser auf.

Untersuchungen haben gezeigt, dass der plattenförmige Isolator vorzugsweise einen Kunststoff und / oder Glas und / oder Aluminiumdioxid und / oder Epoxidharz und / oder Silikon umfasst oder aus einer derartigen Verbindung besteht. Hierbei ist auch ein mehrschichtiger Aufbau aus verschieden Materialien umfasst. Insbesondere lassen sich beispielweise die beiden Bausteine, also Senderbaustein und der Empfängerbaustein jeweils mit einer dünnen als transparente Silikonklebeschicht ausgebildeten Verbindungsschicht kraftschlüssig mit einem dünnen Glasplättchen verbinden. Es versteht sich, dass sich der Senderbaustein und der Empfängerbaustein mit dem Isolator auch mittels anderen Verbindungsmaterialien und / oder Befestigungsmittel zu einem Stapel fügen lassen.

In einer bevorzugten Weiterbildung ist die Dicke des Isolators kleiner als 0,5 mm, vorzugsweise kleiner als 0,3 mm, jedoch größer als 50µm. Es versteht sich hierbei, dass die Dicke des Isolators so gewählt ist, dass eine Durchschlagsfestigkeit zwischen dem Senderbaustein und dem Empfängerbaustein von größer als 2kV gewährleistet ist. Hierbei ist es vorteilhaft, wenn der plattenförmige Isolator auf allen Seiten aus dem Stapel um wenigstens 5 µm hervorsteht, d.h. der Isolator bildet einen umlaufenden Balkon aus.

In einer anderen Ausführungsform ist die Gesamtdicke des Stapels aus Senderbaustein und Isolator und Empfängerbaustein ungehäust kleiner als 3 mm, vorzugsweise kleiner als 2 mm, höchst vorzugsweise kleiner als 1,2 mm, jedoch dicker als 0,2 mm.

Zur Erhöhung des Kopplungswirkungsgrades zwischen dem Senderbaustein und dem Empfängerbaustein ist es vorteilhaft, dass die Emissionswellenlänge des Senderbausteins gleich oder um maximal 10 % kleiner als die Absorptionskante des Empfängerbausteins ist. In einer weiteren Ausbildung umfassen der Senderbaustein und der Empfängerbaustein ein III-V Material oder bestehen aus dem III-V Material. Insbesondere umfasst der Empfängerbaustein ein GaAs und / oder ein Ge-Substrat. Vorzugsweise umfasst der Empfängerbaustein ein (Al)GaAs und / oder ein InGaP und / oder ein InGaAs Material. Es sei angemerkt, dass ein in Klammer gesetztes Element, hier beispielsweise Aluminium, vorhanden sein kann, aber nicht vorhanden sein muss.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die lateralen und die vertikalen Erstreckungen sind nicht maßstäblich und weisen, sofern nicht anders angegeben, auch keine ableitbaren geometrischen Relationen zueinander auf. Darin zeigt:
- Figur 1: eine Querschnittsansicht auf eine erste erfindungsgemäße Ausführungsform mit einer Ausschnittsvergrößerung,
- Figur 2: eine Querschnittsansicht auf eine zweite erfindungsgemäße Ausführungsform,
- Figur 3a: eine Querschnittsansicht auf eine dritte erfindungsgemäße Ausführungsform mit einem Substrat,
- Figur 3b: eine Querschnittsansicht auf eine vierte erfindungsgemäße Ausführungsform mit einem Substrat,
- Figur 4: eine detaillierte Darstellung des Empfängerbausteins,
- Figur 5: eine Querschnittsansicht auf eine gehäuste Ausführungsform.

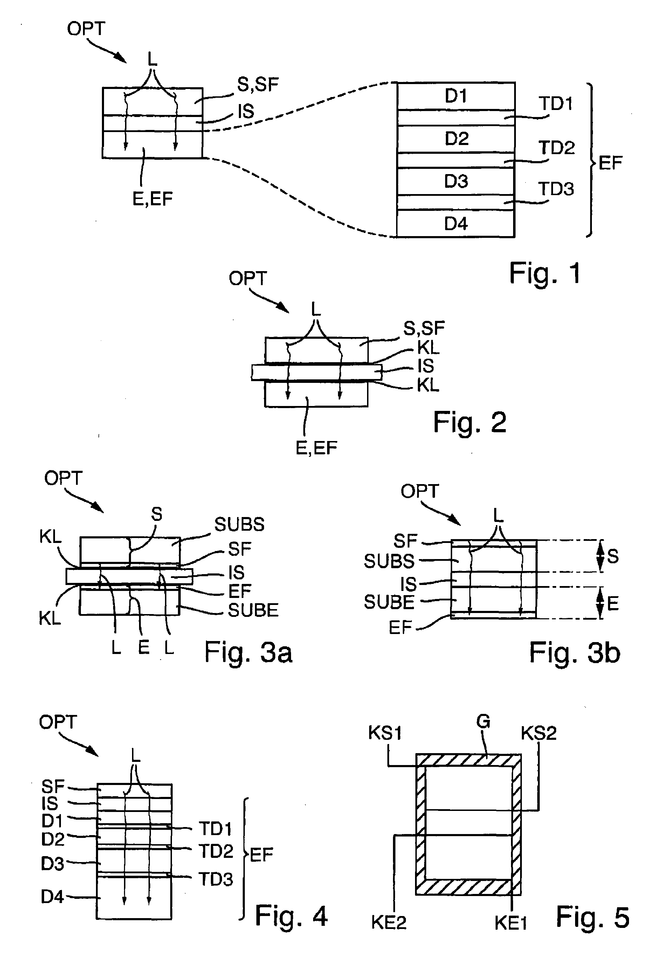

Die Abbildung der Figur 1 zeigt eine Querschnittsansicht auf eine erste erfindungsgemäße Ausführungsform eines stapelförmigen Optokopplerbausteins OPT zusammen mit einer Ausschnittsvergrößerung. Der Optokopplerbaustein OPT umfasst einen Senderbaustein S mit einem Sendebereich SF mit einer Oberfläche und einen Empfängerbaustein E mit einer Empfangsbereich EF und mit einer Oberfläche. Die Ausschnittvergrößerung zeigt einen prinzipiellen Aufbau eines Empfangsbereichs EF auf. Vorliegend ist die Flächengröße des Empfangsbereichs EF und des Empfängerbausteins E identisch mit der Flächengröße des Sendebereichs SF und des Senderbausteins S. Weiterhin umfasst der Optokopplerbaustein OPT einen plattenförmigen elektrischen Isolator IS, wobei der Isolator IS zwischen dem Senderbaustein S und dem Empfängerbaustein E ausgebildet ist.

Insgesamt ist der Senderbaustein S und der Empfängerbaustein E und der Isolator IS stapelförmig aufeinander angeordnet und miteinander kraftschlüssig verbunden, wobei der Senderbaustein S und der Empfängerbaustein E voneinander galvanisch getrennt jedoch miteinander optisch gekoppelt sind. Der Isolator IS ist zumindest für die Emissionswellenlängen des Senderbausteins S transparent. Die drei Bausteine S, IS und E sind derart angeordnet, dass die Schwerelinie der Oberfläche des Sendebereichs SF und die Schwerelinie der Oberfläche des Empfangsbereichs EF exakt zueinander parallel sind und die beiden Schwerelinien keinen Versatz aufweisen. Das Licht L des Senderbausteins S wirkt durch den Isolator IS unmittelbar auf den Empfängerbaustein E ein.

In der Ausschnittsvergrößerung ist der Empfangsbereich EF des Empfängerbausteins E detailliert dargestellt. In einer elektrotechnischen Betrachtung weist der Empfängerbaustein E eine Anzahl von vier zueinander in Serie geschalteten Teilspannungsquellen auf. Jede der Teilspannungsquellen umfasst eine Halbleiterdiode D1 bis D4. Die Dioden D1 bis D4 weisen einen nicht dargestellten p-n Übergang auf. Zwischen jeweils zwei aufeinanderfolgenden Teilspannungsquellen ist jeweils eine Tunneldiode TD1 bis TD3 angeordnet. Die Teilspannungsquellen und die Tunneldioden TD1 bis TD3 sind zusammen monolithisch integriert. Bei einer Bestrahlung durch den Senderbaustein S erzeugt der Empfängerbaustein E eine Gesamtspannung oberhalb von 2 V, wobei die einzelnen Dioden des Stapels nahezu eine identische Teilspannung erzeugen.

In der Abbildung der Figur 2 ist eine Querschnittsansicht auf eine zweite erfindungsgemäße Ausführungsform eines Optokopplerbausteins OPT dargestellt. Im Folgenden werden nur die Unterschiede zu der Ausführungsform dargestellt in der Abbildung der Figur 1 erläutert. Die Fläche des plattenförmigen Isolators IS ist größer als die Fläche des Senderbausteins S und die Fläche des Empfängerbausteins E, sodass der Isolator IS umlaufend balkonartig aus dem Stapel hervorsteht. Zwischen dem Isolator IS und dem Senderbaustein S einerseits und dem Isolator IS und dem Empfängerbaustein E sind jeweils eine transparente Verbindungsschicht KL ausgebildet. Mittels der Verbindungsschicht KL sind der Empfängerbaustein E und der Senderbaustein S kraftschlüssig mit dem Isolator IS zu einem Stapel verbunden.

In der Abbildung der Figur 3a ist eine Querschnittsansicht auf eine dritte erfindungsgemäße Ausführungsform eines Optokopplerbausteins OPT dargestellt. Im Folgenden werden nur die Unterschiede zu der Ausführungsform dargestellt in der Abbildung der Figur 1 und der Figur 2 erläutert. Der Senderbaustein S umfasst zusätzlich zu dem Sendebereich SF eine Substratschicht SUBS. Der Empfängerbaustein E umfasst zusätzlich zu dem Empfängerbereich EF eine Substratschicht SUBE. Beide Substratschichten SUBS und SUBE sind als Trägerschichten ausgebildet. Zwischen den beiden Substratschichten SUBS und SUBE ist der Sendebereich SF und der Empfangsbereich EF angeordnet. Auf der Oberseite und Unterseite des plattenförmigen Isolators IS ist jeweils die ebenfalls transparente Verbindungsschicht KL ausgebildet. Die Verbindungsschicht KL ist dünner als 0,2 mm, vorzugsweise dünner als 0,02 mm und verbindet die Oberseite des Isolators stoffschlüssig mit dem Sendebereich SF und die Unterseite des Isolators stoffschlüssig mit dem Empfangsbereich. Der Vorteil der Anordnung ist, dass das Licht L des Sendebereichs SF unmittelbar durch den Isolator IS auf den Empfangsbereich EF trifft.

In der Abbildung der Figur 3b ist eine Querschnittsansicht auf eine vierte erfindungsgemäße Ausführungsform eines Optokopplerbausteins OPT dargestellt. Im Folgenden werden nur die Unterschiede zu der Ausführungsform dargestellt In der Abbildung der Figur 3a erläutert. Zwischen dem Sendebereich SF und dem Isolator IS ist die Substratschicht SUBS und zwischen dem Empfangsbereich EF und dem Isolator IS ist die Substratschicht SUBE angeordnet. Vorliegend durchläuft das Licht L zusätzlich zu dem Isolator auch die beiden Substratschichten SUBS und SUBE, um auf den Empfangsbereich EF absorbiert zu werden. Es versteht sich, dass die Substratschichten SUBS und SUBE eine geringe Absorption in dem Bereich der Emissionswellenlänge des Senderbausteins S aufweisen.

In der Abbildung der Fig. 4 ist eine Querschnittsansicht auf eine detaillierte Darstellung des Empfängerbausteins E als Teil des Optokopplerbaustein OPT dargestellt. Nachfolgend werden nur die Unterschiede zu der Ausführungsform der Figur 1 erläutert. Die Schichtdicken der Dioden D1 bis D4 nehmen mit dem Abstand der jeweiligen Diode von dem Isolator IS kontinuierlich zu, wobei die vierte Diode D4 die größte Schichtdicke aufweist.

In der Abbildung der Fig. 5 ist eine Querschnittsansicht auf eine gehäuste Ausführungsform eines Optokopplerbaustein OPT dargestellt. Nachfolgend werden nur die Unterschiede zu den vorangegangenen Ausführungsformen erläutert. Der Stapel aus Senderbaustein S und Isolator IS und Empfängerbaustein E sind in einem gemeinsamen Gehäuse G integriert. Der Senderbaustein S weist eine ersten elektrischen Anschlusskontakt KS1 und eine zweiten elektrischen Kontaktanschluss KS2 auf. Der Empfängerbaustein E weist einen ersten elektrischen Anschlusskontakt KE1 und einen zweiten elektrischen Anschlusskontakt KE2 auf.

## Patentansprüche

1. Stapelförmiger Optokopplerbaustein (OPT), aufweisend
- einen Senderbaustein (S) mit einem Sendebereich (SF), wobei der Sendebereich (SF) eine Oberfläche aufweist, und
einen Empfängerbaustein (E) mit einem Empfangsbereich (EF), wobei der Empfangsbereich (EF) eine Oberfläche aufweist, und
- einen plattenförmigen elektrischen Isolator (IS), und
- wobei der Isolator (IS) zwischen dem Senderbaustein (S) und dem Empfängerbaustein (E) ausgebildet ist, und
- der Senderbaustein (S) und der Empfängerbaustein (E) und der Isolator stapelförmig aufeinander angeordnet sind, und
- der Senderbaustein (S) und der Empfängerbaustein (E) voneinander galvanisch getrennt jedoch miteinander optisch gekoppelt sind, wobei der Isolator (IS) wenigstens für ein Teil der Emissionswellenlängen des Sendebereichs (SF) transparent ist, und
- die Schwerelinie der Oberfläche des Sendebereichs (SF) und die Schwerelinie der Oberfläche des Empfangsbereichs (EF) im Wesentlichen oder exakt zueinander parallel sind, und
- der Versatz zwischen den beiden Schwerelinien kleiner als die Hälfte oder kleiner als ein Zehntel oder kleiner als ein fünfzigstel der Entfernung der jeweiligen Schwerelinien zu einer Außenkante der Oberfläche des Sendebereichs (SF) oder zu einer Außenkante der Oberfläche des Empfangsbereichs (EF) ist, so dass das Licht des Senderbausteins (S) überwiegend oder ausschließlich durch den Isolator (IS) auf den Empfängerbaustein (E) einwirkt, und
der Isolator (IS) auf allen Seiten aus dem Stapel balkonförmig um maximal 250 µm hervorsteht, und
- der Empfängerbaustein (E) eine Anzahl N zueinander in Serie geschalteter Teilspannungsquellen aufweist, wobei N eine natürliche Zahl und ≥ 2 ist, und
- die Abweichung der Teilspannungen der einzelnen Teilspannungsquellen untereinander kleiner als 20% ist, und
- jede der Teilspannungsquellen eine Halbleiterdiode (D1,.. ,DN) mit einen p-n Übergang aufweist, und
- zwischen jeweils zwei aufeinanderfolgenden Teilspannungsquellen eine Tunneldiode (TD1, ,TDN-1) ausgebildet ist, wobei
- die Teilspannungsquellen und die Tunneldioden (TD1, ,TDN-1) zusammen monolithisch integriert sind.

2. Integrierter Optokoppler (OPK) nach Anspruch 1, **dadurch gekennzeichnet, dass** der Unterschied zwischen der Größe der Oberfläche des Sendebereichs (SF) und der Größe der Oberfläche des Empfangsbereich (EF) kleiner als 20% ist.

3. Integrierter Optokoppler (OPK) nach Anspruch 1 oder Anspruch 2, **dadurch gekennzeichnet, dass** die Oberfläche des Sendebereichs (SF) und die Oberfläche des Empfangsbereichs (EF) eine viereckige Form aufweisen und die größte Kantenlänge des jeweiligen Vierecks kleiner als 2 mm ist.

4. Integrierter Optokoppler (OPK) nach einem oder mehreren der vorangegangenen Ansprüche, **dadurch gekennzeichnet, dass** der Stapel aus Senderbaustein (S) und Isolator (IS) und Empfängerbaustein (E) in einem gemeinsam Gehäuse (G) integriert sind.

5. Integrierter Optokoppler (OPK) nach einem oder mehreren der vorangegangenen Ansprüche, **dadurch gekennzeichnet, dass** die Oberfläche des Sendebereichs (SF) und die Oberfläche des Empfangsbereichs (EF) gleich groß sind und dass mit Ausnahme von den elektrischen Anschlussbereichen der gesamte Sendebereich (SF) Licht (L) emittiert und der gesamte Empfangsbereich (EF) Licht (L) absorbiert.

6. Integrierter Optokoppler (OPK) nach einem oder mehreren der vorangegangenen Ansprüche, **dadurch gekennzeichnet, dass** die Oberfläche des Sendebereichs (SF) und die Oberfläche des Empfangsbereichs (EF)
quadratisch sind und jeweils eine Grundfläche größer als 0,2 x 0,2 mm² und kleiner als 4 mm² oder kleiner als 1 mm² aufweisen.

7. Integrierter Optokoppler (OPK) nach einem der vorangegangenen Ansprüche, **dadurch gekennzeichnet, dass** der Senderbaustein (S) einen optischen Spiegel für die Wellenlänge des Senders oder eine RCLED oder einen oberflächenemittierenden Laser aufweist.

8. Integrierter Optokoppler (OPK) nach einem oder mehreren der vorangegangenen Ansprüche, **dadurch gekennzeichnet, dass** der plattenförmige Isolator (IS) aus Kunststoff und oder aus Glas und oder aus Aluminiumdioxid und oder aus Epoxidharz und oder aus Silikon besteht.

9. Integrierter Optokoppler (OPK) nach einem oder mehreren der vorangegangenen Ansprüche, **dadurch gekennzeichnet, dass** der Isolator (IS) auf allen Seiten aus dem Stapel um wenigstens 5 µm hervorsteht.

10. Integrierter Optokoppler (OPK) nach einem oder mehreren der vorangegangenen Ansprüche, **dadurch gekennzeichnet, dass** die Dicke des Isolators (IS) kleiner als 0.5 mm mindestens jedoch 50 µm ist.

11. Integrierter Optokoppler (OPK) nach einem oder mehreren der vorangegangenen Ansprüche, **dadurch gekennzeichnet, dass** die Emissionswellenlänge des Sendebereichs (SF) gleich oder um maximal 10 % kleiner als die Absorptionskante des Empfängerbereichs (EF) ist.

12. Integrierter Optokoppler (OPK) nach einem oder mehreren der vorangegangenen Ansprüche, **dadurch gekennzeichnet, dass** der Senderbaustein (S) und der Empfängerbaustein (E) aus einem III-V Material ausgebildet sind.

13. Integrierter Optokoppler (OPK) nach einem oder mehreren der vorangegangenen Ansprüche, **dadurch gekennzeichnet, dass** der Empfängerbaustein (E) ein GaAs und / oder ein Ge-Substrat umfasst.

14. Integrierter Optokoppler (OPK) nach einem oder mehreren der vorangegangenen Ansprüche, **dadurch gekennzeichnet, dass** der Empfängerbaustein (E) ein (Al)GaAs und / oder ein InGaP und / oder ein InGaAs Material umfasst.

15. Integrierter Optokoppler (OPK) nach einem oder mehreren der vorangegangenen Ansprüche, **dadurch gekennzeichnet, dass** der Empfängerbaustein (E) und der Senderbaustein (S) entlang der Stapelrichtung einen pyramidenstumpfartige Ausbildung aufweist, wobei der Unterschied zwischen der Flächengröße der Unterseite des Pyramidenstumpfs und der Oberseite des Pyramldenstumpfs wenigstens 5 µm² beträgt.

16. Integrierter Optokoppler (OPK) nach einem oder mehreren der vorangegangenen Ansprüche, **dadurch gekennzeichnet, dass** die Oberfläche des Sendebereichs (SF) unmittelbar an der Oberseite des Isolators (IS) und die Oberfläche des Empfangsbereichs (EF) unmittelbar an der Unterseite des Isolators (IS) angeordnet sind, so dass die Oberfläche des Sendebereich (SF) und die Oberfläche des Empfangsbereich (EF) einander zugewandt sind.

17. Integrierter Optokoppler (OPK) nach einem oder mehreren der Ansprüche 1 bis 15, **dadurch gekennzeichnet, dass** der Senderbaustein (S) eine Substratschicht (SUBS) aufweist und die Substratschicht (SUBS) an der Oberseite des Isolators (IS) angeordnet ist und der Empfängerbaustein (E) eine Substratschicht (SUBE) aufweist und die Substratschicht (SUBE) an der Unterseite des Isolators (IS) angeordnet ist, so dass die beiden Substratschichten (SUBS, SUBE) unmittelbar einander zugewandt sind.
